# FASCICULE DE BREVET EUROPEEN

(11) **EP 3 707 563 B1**
(45) Date de publication et mention de la délivrance du brevet: **16.11.2022**
(21) Numéro de dépôt: 18807435.5
(22) Date de dépôt: 12.11.2018
(51) Int. Cl.: G04B 1/22, G04B 1/10, B81B 3/00

(54) **ORGANE MOTEUR D'HORLOGERIE**
ANTRIEBSORGAN EINER UHR
TIMEPIECE DRIVE MEMBER

(30) Priorité: 10.11.2017 EP 17200971
(43) Date de publication de la demande: 16.09.2020
(73) Titulaire: Patek Philippe SA Genève, 1204 Genève (CH)
(72) Inventeur: LE BRIS, Jean-Baptiste, 74970 Marignier (FR)
(74) Mandataire: Micheli & Cie SA
(86) Numéro de dépôt international: PCT/IB2018/058865
(87) Numéro de publication internationale: WO 2019/092664

(56) Documents cités:
- EP-A2- 2 137 578
- FR-A- 661 811
- RU-C2- 2 498 381
- KYLER A. TOLMAN ET AL: "Compliant constant-force linear-motion mechanism", MECHANISM AND MACHINE THEORY, vol. 106, 1 décembre 2016 (2016-12-01), pages 68-79, XP055477345, AMSTERDAM, NL ISSN: 0094-114X, DOI: 10.1016/j.mechmachtheory.2016.08.009

## Description

La présente invention concerne un organe moteur pour l'horlogerie, en particulier un organe moteur à force sensiblement constante.

L'organe moteur d'horlogerie selon l'invention peut être, soit un organe moteur d'un mouvement horloger agencé pour entraîner un rouage de finissage, soit un organe moteur d'un mécanisme additionnel tel qu'un mécanisme de sonnerie ou un mécanisme de chronographe.

En horlogerie, on a traditionnellement recours à un barillet comme organe moteur d'un mécanisme horloger. Un barillet est un assemblage d'au moins trois éléments : un ressort de barillet consistant en une lame ressort en forme de spirale, un tambour de barillet servant de logement audit ressort, ledit tambour pouvant tourner librement sur un arbre de barillet (axe pivotant entre pont et platine), et un couvercle de barillet pour fermer le tambour de barillet, ledit couvercle pouvant également tourner librement sur l'arbre de barillet. Hors du tambour de barillet, la lame ressort a la forme d'un S retourné. Le déroulement de la lame, enroulée contre le diamètre de la bonde de l'arbre de barillet et cherchant à reprendre sa forme initiale, produit l'énergie nécessaire au fonctionnement du mécanisme horloger.

Un inconvénient d'un tel organe moteur est que son rendement est affecté par les frottements des spires du ressort en spirale les unes contre les autres et contre l'intérieur du tambour de barillet, lors du dévidement du barillet. Pour atténuer ces frottements, il est habituel de lubrifier les spires du ressort et de déposer un revêtement anti-frottements dans le tambour. Malgré cela, un tel organe moteur subit des pertes d'énergie d'environ 15% dues aux frottements.

Un autre inconvénient d'un tel organe moteur est que la fabrication et la mise en forme de la lame ressort qu'il contient, de sa forme en S retourné à sa forme en spirale, doit fortement tenir compte de la limite d'élasticité du matériau constituant la lame ressort. De plus, la mise en place du ressort en spirale logé dans le tambour de barillet est basée sur une longue expérience de l'horloger et nécessite de nombreuses étapes de manipulation. Il s'agit en outre d'un assemblage de plusieurs éléments.

Un tel organe moteur est donc coûteux et difficile à fabriquer.

En outre, le moment de force délivré par un tel organe moteur n'est pas constant, ce qui affecte l'isochronisme du mécanisme horloger. Pour atténuer ce problème, certains mouvements horlogers emploient un ressort intermédiaire de type spiral entre l'organe moteur et l'échappement. Un inconvénient de cette solution est qu'elle complexifie le mouvement en introduisant un élément supplémentaire.

WO2008/114071 A2 divulgue un organe moteur d'horlogerie comportant au moins un ressort hélicoïdal.

Le but de la présente invention est de fournir un organe moteur alternatif au barillet comprenant un ressort en spirale traditionnellement utilisé qui permette de pallier, au moins en partie, les inconvénients précités.

L'invention propose à cette fin un organe moteur d'horlogerie comprenant un support, un organe élastique et un élément d'entraînement, caractérisé en ce que ledit élément d'entraînement est apte à être mis en mouvement et guidé en translation par rapport au support par ledit organe élastique, cette translation permettant la délivrance d'une force à un mécanisme horloger.

La présente invention propose également un mécanisme horloger comprenant un tel organe moteur d'horlogerie, ledit mécanisme comprenant typiquement un mécanisme de remontoir agencé pour armer l'organe moteur et un rouage agencé pour être entraîné par l'organe moteur, ainsi qu'une pièce d'horlogerie telle qu'une montre bracelet ou une montre de poche comprenant un tel mécanisme horloger.

La pièce d'horlogerie selon l'invention comprend de préférence une boîte de montre et un mécanisme de remontoir dudit organe moteur, ledit mécanisme de remontoir étant actionnable depuis l'extérieur de la boîte de montre.

Enfin, la présente invention propose l'utilisation d'un tel organe moteur comme source d'énergie pour un mécanisme horloger indépendant du rouage de finissage.

L'organe moteur d'horlogerie selon l'invention permet la délivrance d'une force par un déplacement rectiligne en translation d'un élément d'entraînement. Cela annule la nécessité de spires ainsi que l'ensemble des problèmes qui y sont associés.

L'organe moteur selon l'invention présente également l'avantage d'améliorer nettement le rendement (perte d'énergie moyenne comprise entre 0 et 1% seulement contre 15% environ pour un barillet à ressort en spirale traditionnel). En effet, l'organe élastique qui le compose ne subit pas de frottements.

En outre, l'organe moteur selon l'invention présente l'avantage de délivrer une force sensiblement constante, améliorant ainsi l'isochronisme du mouvement horloger auquel il est associé, sans nécessiter de ressort intermédiaire entre l'organe moteur et l'échappement.

D'autres caractéristiques et avantages de la présente invention apparaîtront à la lecture de la description détaillée suivante faite en référence aux dessins annexés dans lesquels :
- la figure 1 est une vue en perspective de dessus d'une partie d'un mécanisme horloger intégrant un organe moteur d'horlogerie selon un mode de réalisation particulier de l'invention ;
- la figure 2 est une vue en perspective de dessous du mécanisme représenté à la figure 1 ;
- les figures 3a et 3b sont des représentations schématiques en vue de dessus de l'organe moteur représenté à la figure 1 isolé, respectivement au repos et pré-armé ;
- la figure 4 (courbe C₀) est une représentation graphique de la force exercée dans l'organe moteur des figures 3a et 3b en fonction de son état d'armage ;
- la figure 5 représente graphiquement la force de rappel élastique exercée par une lame travaillant en flambage appartenant à l'organe moteur représenté aux figures 3a et 3b (courbe C₁) ainsi que la contrainte maximale de Von Mises exercée sur cette lame (courbe C₂) ;
- la figure 6 représente graphiquement la force de rappel élastique exercée par un ensemble de lames travaillant en flexion appartenant à l'organe moteur représenté aux figures 3a et 3b (courbe C₃) ainsi que la contrainte maximale de Von Mises exercée sur cet ensemble de lames (courbe C₄) ;
- la figure 7 est une représentation dans un même graphique des courbes Co, C₁ et C₃.

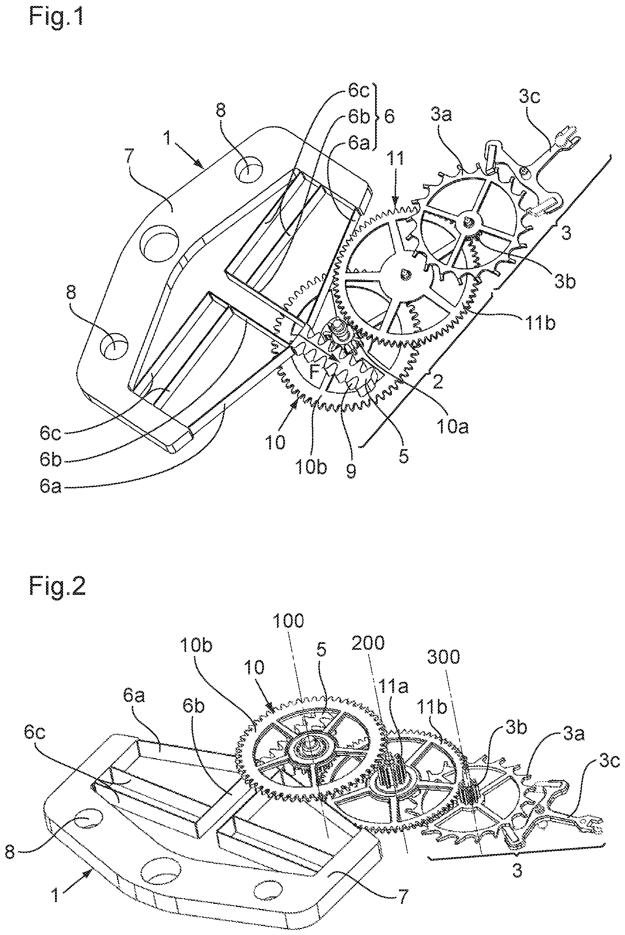

Les figures 1 et 2 représentent une partie d'un mécanisme horloger, plus précisément d'un mouvement horloger, comprenant un organe moteur d'horlogerie 1 selon un mode de réalisation particulier de l'invention.

Ce mouvement horloger comprend en outre, notamment, un rouage de finissage 2 et un échappement 3 tels qu'illustrés aux figures 1 et 2. Avantageusement, ledit mouvement horloger comprend également un mécanisme de remontoir (non illustré).

Ledit mécanisme de remontoir comprend typiquement une tige de remontoir et un rouage de remontoir. Dans une variante, il pourrait être de type automatique, à masse oscillante.

L'organe moteur 1 illustré aux figures 1 et 2 est typiquement monolithique. Il comprend une crémaillère 5 dentée, se déplaçant en translation et un support 7 rigide.

L'organe moteur 1 comprend également un organe élastique 6 reliant ladite crémaillère 5 audit support 7. Le support 7 est en une seule partie dans l'organe moteur 1 représenté à la figure 1 mais pourrait comprendre plusieurs parties fixes les unes par rapport aux autres, par exemple plusieurs parties fixées sur un même bâti.

L'organe élastique 6 comprend typiquement :
- une lame élastique 6a travaillant en flambage, ladite lame 6a étant interrompue dans sa partie centrale par la crémaillère 5 et ayant ses deux extrémités jointes audit support 7 ;
- une paire de lames élastiques de jonction 6b travaillant en flexion, une des extrémités de chaque lame de ladite paire étant reliée à la crémaillère 5 et s'étendant de cette crémaillère 5 vers le support 7 ; et
- deux paires de lames élastiques 6c parallèles, travaillant en flexion et reliant la paire de lames élastiques de jonction 6b au support 7.

Le support 7 est monté fixe par rapport au mouvement, par exemple dans la platine du mouvement. Il comporte avantageusement des trous 8 destinés à recevoir des moyens de fixation tels que des vis et/ou des goupilles permettant sa fixation, typiquement dans la platine du mouvement.

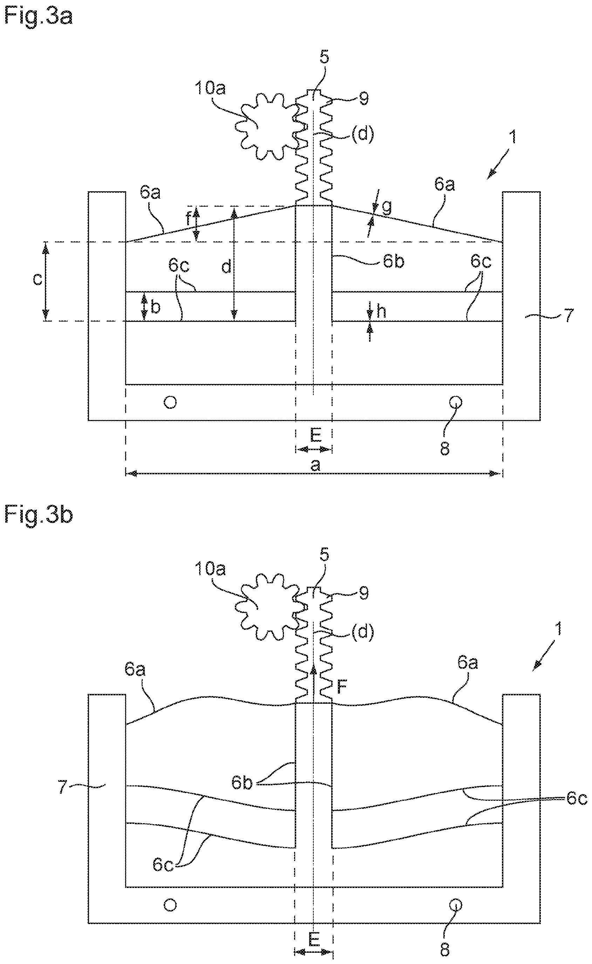

Lors du fonctionnement de l'organe moteur 1, la crémaillère 5 est mobile. Elle est guidée en translation par l'organe élastique 6 et se déplace le long d'une droite (d), comme illustré aux figures 3a et 3b. Dans l'exemple illustré dans ces figures, l'ensemble comprenant l'organe élastique 6 et la crémaillère 5 est symétrique par rapport à cette droite (d).

Pour délivrer de l'énergie, l'organe moteur 1 doit être armé. L'armage de l'organe moteur 1 s'effectue par translation de la crémaillère 5 le long de la droite (d) dans la direction entraînant un effort de compression sur les lames 6a et leur flambage, c'est-à-dire dans la direction du support 7 (sens d'armage). Ce mouvement entraîne une déformation de l'organe élastique 6 qui accumule de l'énergie. A des fins de simplification, la lame élastique 6a de l'organe moteur 1 tel que représenté aux figures 1 et 2 est représentée droite. Elle est en réalité flambée. Lorsqu'il est armé, l'organe moteur 1 est apte à délivrer l'énergie emmagasinée par translation de sa crémaillère 5 le long de la droite (d) dans le sens opposé au sens d'armage.

Avantageusement, le système de remontoir (non représenté) permet d'armer l'organe moteur 1 comme décrit précédemment.

Avantageusement, le système de remontoir engendre, en position active, le débrayage entre l'organe moteur 1 et le rouage de finissage 2 et permet, dans cette position, d'armer l'organe moteur 1. Lorsqu'il est en position inactive, l'embrayage entre l'organe moteur 1 et le rouage de finissage 2 est rétabli. Dans cette position inactive, il ne permet plus d'armer l'organe moteur 1.

Un tel système de remontoir incluant un système de débrayage/embrayage peut typiquement comprendre un mobile comprenant une roue et un pignon, ledit pignon étant relié cinématiquement à la crémaillère 5 de l'organe moteur 1, ladite roue étant reliée cinématiquement au rouage de finissage 2, lesdits roue et pignon étant solidaires en rotation lorsque ledit pignon est entraîné en rotation dans un premier sens, ce premier sens correspondant au sens dans lequel tourne ledit pignon lorsqu'il reçoit de l'énergie de l'organe moteur, mais non solidaires en rotation lorsque ledit pignon est entraîné en rotation dans un second sens, opposé au premier, c'est-à-dire lorsque ce pignon permet de remonter l'organe moteur 1.

Dans le mode de réalisation illustré à la figure 1, la crémaillère 5 comprend une denture 9 permettant la liaison avec le rouage de finissage 2. La denture 9 de la crémaillère 5 engrène typiquement avec un premier pignon 10a du rouage de finissage 2 et est ainsi apte à le mettre en mouvement.

Le mouvement horloger représenté aux figures 1 et 2 comprend le premier pignon 10a, ledit pignon 10a pivotant autour d'un axe 100 (virtuel), engrenant avec la denture 9 de la crémaillère 5 et étant relié cinématiquement à la roue d'échappement 3a de l'échappement 3.

Avantageusement, le mouvement horloger représenté aux figures 1 et 2 comprend un premier mobile 10 pivotant autour de l'axe 100, ledit premier mobile 10 comprenant ledit premier pignon 10a et une première roue 10b qui lui est coaxiale et solidaire en rotation. De préférence encore, la roue d'échappement 3a est coaxiale et solidaire d'un pignon d'échappement 3b engrenant avec une deuxième roue 11b d'un deuxième mobile 11 pivotant autour d'un axe 200 (virtuel), ledit deuxième mobile 11 comportant également un deuxième pignon 11a coaxial et solidaire en rotation de la deuxième roue 11b et engrenant avec la première roue 10b dudit premier mobile 10.

Lorsque l'organe moteur 1 de la figure 1 est armé, il se désarme en exerçant une force F tendant à déplacer en translation sa crémaillère 5 le long de la droite (d) dans le sens de la flèche F de la figure 1 (sens opposé au sens d'armage). La denture 9 de la crémaillère 5 engrenant avec le pignon premier 10a du premier mobile 10, ce premier pignon 10a est entraîné en rotation dans le sens anti-horaire de la figure 1. La première roue 10b qui lui est solidaire en rotation est également entraînée en rotation dans le sens anti-horaire et engendre à son tour la rotation dans le sens horaire du deuxième pignon 11a et de la deuxième roue 11b. Enfin la deuxième roue 11b entraîne en rotation le pignon d'échappement 3b et la roue d'échappement 3a qui coopère avec l'ancre d'échappement 3c dans le sens anti-horaire de la figure 1.

En l'absence d'un dispositif limitant le déplacement de sa crémaillère 5, l'organe moteur 1 se désarme jusqu'à ce que son organe élastique 6 soit au repos, c'est-à-dire dans la position dans laquelle toutes ses lames élastiques 6a, 6b, 6c sont au repos (n'exercent aucune force de rappel élastique). Une fois cette position atteinte, l'organe moteur 1 ne délivre plus d'énergie et doit être armé à nouveau pour fournir de l'énergie. Dans l'exemple illustré, lorsque l'organe 6 est en position de repos (cf. figure 3a) la droite (d) est sensiblement parallèle aux lames 6b et sensiblement équidistante de chacune de ces lames.

Selon l'invention, l'ensemble des lames élastiques 6a, 6b, 6c de l'organe élastique 6 est conçu, pour exercer, dans l'organe moteur 1 une force de rappel élastique F sensiblement constante sur une plage de positions prédéterminée de la crémaillère 5 par rapport au support 7 le long de la droite (d), c'est-à-dire une force de rappel élastique F ne variant pas de plus de 10%, de préférence 5%, de préférence 3%, de préférence 2%, de préférence encore 1% sur ladite plage de positions prédéterminée.

Pour la compréhension de l'invention, le comportement de l'organe moteur 1, considéré isolément, c'est-à-dire libre de toute interaction avec le rouage de finissage 2 ou le rouage de remontoir, est décrit ci-dessous.

L'organe moteur 1 isolé représenté schématiquement à la figure 3a peut être armé par translation de sa crémaillère 5 le long de la droite (d) dans son sens d'armage d'une distance Δ. La position dans laquelle Δ=0 correspond à la position de repos de l'organe élastique 6 de l'organe moteur 1. La figure 3a représente l'organe moteur 1 isolé dans ladite position de repos. La valeur de Δ augmente lorsque la crémaillère 5 se rapproche du support 7 (vers le bas à la figure 3a).

De manière générale, lorsque la crémaillère 5 est dans la position dans laquelle la valeur de Δ associée est égale à x mm, on dit que l'organe moteur 1 est armé x mm.

Comme indiqué précédemment, lors de l'armage, l'organe élastique 6 se déforme pour exercer, dans l'organe moteur 1 armé, une force de rappel F(Δ) dans le sens opposé au sens d'armage, cette force dépendant de la position Δ de la crémaillère 5 et tendant à faire revenir l'organe moteur 1 dans son état de repos, c'est-à-dire dans notre exemple à éloigner la crémaillère 5 du support 7. La figure 3b représente l'organe moteur 1 isolé après armage. La flèche F représentée à la figure 3b illustre la force de rappel F(Δ), qui tend à faire revenir l'organe moteur 1 dans son état de repos.

L'organe moteur 1 représenté aux figures 3a et 3b correspond à un organe moteur 1 particulier réalisé par la demanderesse dont les dimensions sont, lorsqu'il est à l'état de repos, celles indiquées dans le tableau 1 ci-dessous.

**Tableau 1 : Dimensions de l'organe moteur 1 particulier réalisé par la demanderesse, isolé et à l'état de repos**

| Référence (Fig. 3a) | Grandeur | Valeur | Unité |
|---|---|---|---|
| a | Longueur | 19 | mm |
| b | Espace entre les lames en flexion 6c | 1.78 | mm |
| c | Espace entre la lame 6a et la lame 6c inférieure | 4.75 | mm |
| d | Largeur | 7 | mm |
| E | Espace d'ouverture E de l'organe moteur 1 au repos | 1.78 | mm |
| f | Flèche de la lame 6a | 1.8 | mm |
| g | Epaisseur lame 6a | 100 | µm |
| h | Epaisseur lames 6b et 6c | 118.65 | µm |
| - | Hauteur des lames | 1.5 | mm |

Les grandeurs **g** : « épaisseur lame 6a » et **h** : « épaisseur lames 6b et 6c » se mesurent dans le plan dans lequel est représenté l'organe moteur 1 tandis que la grandeur « hauteur » se mesure perpendiculairement à ce plan.

Les lames élastiques de jonction 6b travaillant en flexion donnent un degré de liberté aux lames élastiques 6c qui peuvent s'écarter, augmentant ainsi la valeur de la distance E (figures 3a et 3b). Ce degré de liberté est nécessaire pour le bon fonctionnement du mécanisme, cependant, il pourrait être obtenu par tout autre moyen convenable. La valeur de E dépend de l'état d'armage de l'organe moteur 1. Lorsque l'organe moteur 1 est au repos, l'espace d'ouverture E a une valeur égale à 1,78mm.

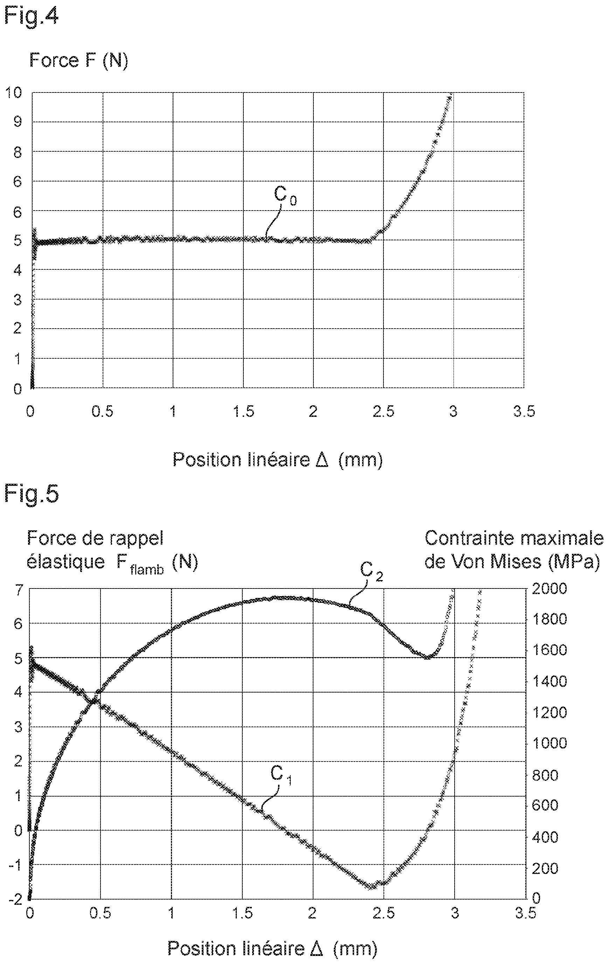

En référence à la figure 4, soit Δ la position de la crémaillère 5 de l'organe moteur 1 isolé le long de la droite (d), tel que défini précédemment ; la figure 4 représente l'évolution F(Δ) de la force F exercée par la crémaillère 5 en direction de la flèche F (*cf*. figure 3b), cette force étant la résultante des forces de rappel élastique exercées par les lames élastiques 6a, 6b et 6c de l'organe élastique 6. Les valeurs de la force F(Δ), pour chaque position Δ, correspondent à la force nécessaire pour maintenir la crémaillère 5 dans la position Δ correspondante. Ces valeurs sont issues d'une simulation de l'évolution de la force de l'organe moteur 1 particulier isolé réalisé par la demanderesse en fonction de la position Δ de sa crémaillère 5.

Comme cela est visible sur le graphique de la figure 4 (courbe Co), cette force suit une évolution en plusieurs phases :
- pour une position Δ comprise entre 0 et une première valeur, la force F augmente rapidement avec la position Δ ; cette phase correspond à une phase d'armage ;
- au-delà de cette première valeur, l'organe moteur 1 est dans une phase stable. En effet, entre cette première valeur et une seconde valeur, la force F est sensiblement constante par rapport à la position Δ (la courbe Co présente un plateau).
- au-delà de cette deuxième valeur, la force F n'est plus sensiblement constante et augmente à nouveau jusqu'à atteindre une valeur limite Fₗᵢₘᵢₜₑ, pour un déplacement Δ = Δₗᵢₘᵢₜₑ. Cette valeur Fₗᵢₘᵢₜₑ dépend des propriétés du matériau dans lequel l'organe moteur 1 est réalisé et est atteinte lorsque l'organe élastique 6 subit la contrainte maximale qu'il peut supporter.

L'organe moteur 1 particulier isolé étudié à la figure 4 est réalisé en acier sulem H1 CK101 (acier de construction non-allié) mais tout matériau approprié peut être utilisé. Par exemple des matériaux tels que le silicium typiquement revêtu d'oxyde de silicium, le Nivaflex^{®} 45/18 (alliage à base de cobalt, nickel et chrome), les polymères, les composites (carbone ou Kevlar^{®} (poly(p-phénylènetéréphtalamide ou PPD-T))) ou les verres métalliques conviennent également et permettent l'obtention d'organes moteurs délivrant une force sensiblement constante sur les mêmes plages de positions mais avec des intensités différentes.

La plage de positions permettant la délivrance d'une force sensiblement constante étant une constante liée à la forme des lames élastiques, la contrainte maximale subie par les lames élastiques doit être inférieure ou égale à la limite élastique (correspondant à Fₗᵢₘᵢₜₑ) du matériau dans lequel elles sont fabriquées. Lors de l'utilisation, il sera donc important de ne pas dépasser Δₗᵢₘᵢₜₑ pour ne pas plastifier ou casser les lames.

Les différents matériaux utilisables cités ci-dessus (mis à part les polymères dont la limite élastique est basse sans l'aspect composite), aux dimensions considérées, peuvent subir, sans risque de déformation plastique ou de rupture, des contraintes (de Von Mises ou principales pour les céramiques) allant jusqu'à 2100 MPa.

L'organe moteur 1 isolé présentant une évolution de la force F(Δ) telle que représentée à la figure 4 diffère des structures élastiques classiques. Ses propriétés reposent sur l'association de différents types de lames élastiques dont les propriétés sont spécifiquement choisies ainsi que sur leur agencement permettant l'addition de leurs forces de rappel élastique.

La courbe C₁ de la figure 5 illustre (en N) la force de rappel élastique F_{flamb} associée à la lame élastique 6a travaillant en flambage en fonction de la position Δ de la crémaillère 5 de l'organe moteur 1 par rapport au support 7, le long de la droite (d). On remarque que pour une certaine plage de valeurs de Δ s'étendant, dans cet organe moteur 1 particulier, d'environ 0,015 mm à environ 2,4 mm, la courbe C₁ associée à la lame 6a est sensiblement droite, de coefficient directeur environ égal à -2,75 (N/mm). En effet, une régression linéaire a été effectuée et donne une équation de droite y= - 2,7523 x + 4,9889 avec R² = 0,9991. La lame élastique 6a de l'organe moteur 1 présente donc, sur cette plage de valeurs au moins, une raideur négative.

La capacité de la lame élastique 6a à travailler en flambage lui permet, lorsqu'elle est considérée isolément, de se comporter comme un bistable ou du moins de posséder une raideur linéaire négative sur une plage de positions données. L'ajustement du rapport entre la flèche f de la lame 6a au repos et son épaisseur ainsi que l'ajustement de sa longueur et de sa hauteur permettent de moduler la linéarité de la portion de droite sur laquelle la lame 6a possède une raideur négative.

La lame élastique 6a est ici préformée droite et travaille en flambage sous l'effet de son armage. Elle pourrait cependant être préformée flambée, c'est-à-dire usinée avec une forme flambée. Encore une autre possibilité consisterait en l'utilisation d'une lame élastique 6a préformée droite puis comprimée lors de l'assemblage de l'organe moteur 1.

La courbe C₂ de cette même figure 5 illustre, quant à elle, la contrainte maximale de Von Mises (en MPa) exercée sur la lame 6a en fonction de la position Δ. Il est à noter que la contrainte de Von Mises exercée sur la lame 6a est inférieure à 2100 MPa sur toute la plage de positions Δ allant de 0,015mm à 2,4mm pour laquelle la courbe C₁ est sensiblement droite.

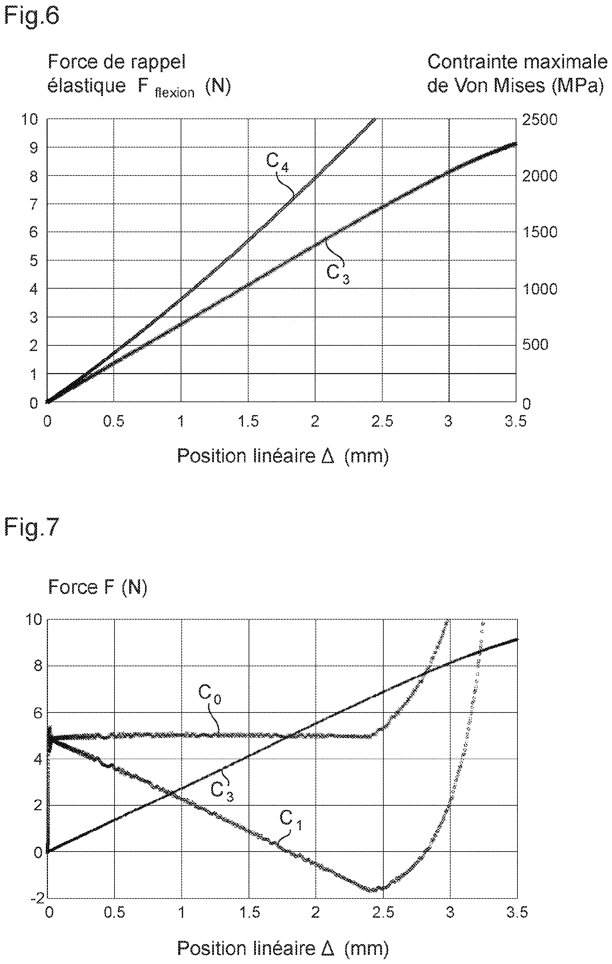

La courbe C₃ de la figure 6 illustre, la force de rappel élastique F_{flexion} associée à l'ensemble des lames 6b, 6c travaillant en flexion en fonction de la position Δ de la crémaillère 5 de l'organe moteur 1 par rapport à son support 7, le long de la droite (d). Comme c'est le cas pour tout type de ressort travaillant en flexion, la courbe C₃ associée à l'ensemble des lames 6b et 6c est une droite sur une plage de valeurs donnée. Les lames 6b, 6c ont une raideur positive et sont choisies pour que la raideur de l'association des lames 6b, 6c en flexion soit environ égale à 2,75 (N/mm), c'est-à-dire pour que le coefficient directeur de la droite F_{flexion}(Δ) soit environ égal à 2,75 (N/mm).

Ainsi les coefficients directeurs des portions de droites associées aux courbes C₁ (F_{flamb}(Δ)) et C₃ (F_{flexion}(Δ)) sont opposés. La courbe C₃ fléchit légèrement pour des valeurs de Δ dépassant 2,6mm, et peut donc être considérée comme une droite de coefficient directeur environ égal à 2,75 pour des valeurs de Δ comprises entre 0 et 2,6mm. Une régression linéaire a été effectuée et donne une équation de droite y=2,7511 x + 0,0045 avec R² = 1.

La courbe C₄ de cette même figure 6 illustre, quant à elle, la contrainte maximale de Von Mises (en MPa) exercée sur l'ensemble des lames 6b et 6c travaillant en flexion en fonction de la position Δ. Il est à noter que la contrainte de Von Mises exercée sur cet ensemble de lames 6b, 6c est inférieure à 2100MPa pour une plage de positions Δ allant de 0mm à 2,1mm. Au-delà de 2,1mm, la contrainte subie sur l'ensemble de lames 6b, 6c dépasse 2100MPa. C'est-à-dire que pour des positions Δ correspondant à un armage de plus de 2,1mm, l'ensemble des lames 6b et 6c est soumis à un risque de déformation plastique voire de rupture.

L'agencement des lames 6a, 6b et 6c de l'organe moteur 1 est tel que la courbe C₀ correspond à la somme des courbes C₁ et C₃ des figures 5 et 6, comme illustré à la figure 7. Ainsi, dans la mesure où les coefficients directeurs des portions de droites associées aux courbes C₁ et C₃ sont opposés, l'association de la raideur négative obtenue par le biais de la lame 6a travaillant en flambage avec la raideur positive obtenue par le biais des lames 6b, 6c travaillant en flexion, permet l'obtention d'une raideur sensiblement nulle, c'est-à-dire d'une force F sensiblement constante, comme illustré aux figures 4 et 7.

L'ensemble des lames de l'organe élastique 6 de l'organe moteur 1 est donc agencé pour exercer une force F(Δ) sensiblement constante sur une plage de positions [Δₘᵢₙ, Δₘₐₓ] de sa crémaillère 5 par rapport à son support 7.

On distinguera la plage [Δₘᵢₙ, Δₘₐₓ] théorique (Δ_{min_théo}, Δ_{max_théo}]), correspondant à la plage de positions de la crémaillère 5 de l'organe moteur 1 par rapport à son support 7 dans laquelle l'organe moteur 1 est potentiellement apte à délivrer une force sensiblement constante de valeur F_{constante}, indépendamment de tout risque de rupture et/ou de déformation plastique, et la plage [Δₘᵢₙ, Δₘₐₓ] d'utilisation ([Δ_{min_utilisation}, Δ_{max_utilisation}]) correspondant à la plage de positions de la crémaillère 5 de l'organe moteur 1 par rapport à son support 7 dans laquelle l'organe moteur 1 est apte à délivrer une force sensiblement constante de valeur F_{constante}, sans risque de déformation plastique ou de rupture de l'une des lames élastiques de son organe élastique.

La plage de positions ([Δ_{min_théo}, Δ_{max_théo}]) correspond à la plage de recoupement des plages de positions dans lesquelles les courbes C₁ et C₃ sont droites. Cette plage de positions s'étend de Δ=0,015mm à Δ=2,4mm dans l'exemple illustré.

La plage ([Δ_{min_utilisation}, Δ_{max_utilisation}]), forcément incluse dans la plage ([Δ_{min_théo}, Δ_{max_théo}]), prend en compte les données des courbes C₂ et C₄. Elle est restreinte à une plage de positions allant de Δ=0,015mm à Δ=2,1mm. En effet, les courbes C₂ et C₄ indiquent que pour des valeurs de Δ supérieures à 2,1mm, la contrainte de Von Mises excède 2100MPa, c'est-à-dire que pour des valeurs de Δ supérieures à Δ_{max_utilisation}=2,1mm, l'organe élastique 6 de l'organe moteur 1 risquerait une déformation plastique ou une rupture. Il est à noter toutefois que, en changeant le matériau utilisé pour la réalisation de l'organe moteur, la limite au-delà de laquelle les lames présentent un risque de déformation plastique ou de rupture pourrait être supérieure à 2100MPa.

La force F_{constante} correspond à la valeur de la force F exercée entre les positions Δₘᵢₙ et Δₘₐₓ considérées (valeur du plateau). Cette force vaut 5N environ dans l'exemple illustré.

Lorsqu'il est armé d'une valeur Δₐᵣₘ d'au moins Δ_{min_utilisation} = Δ_{min_théo} = 0,015mm n'excédant pas Δ_{max_utilisation} (2,1mm dans notre exemple), l'organe moteur 1 étudié se désarme en exerçant une force F sensiblement constante par translation de sa crémaillère 5 le long de la droite (d) dans le sens opposé au sens d'armage, sur une plage de positions de sa crémaillère 5 par rapport à son support 7 allant de ladite valeur d'armage Δₐᵣₘ jusqu'à une valeur correspondant à Δ=Δₘᵢₙ. Si aucune butée ne l'empêche de se désarmer complètement l'organe moteur 1 se désarmera jusqu'à ce que Δ=0, c'est-à-dire jusqu'à sa position de repos. La force F alors exercée entre les positions Δ=Δₘᵢₙ et Δ=0 sera d'intensité décroissante.

Si l'organe moteur 1 est armé d'une valeur Δ supérieure à Δ_{max_utilisation} mais inférieure à Δ_{max_théorique}, il est possible que ce dernier soit rompu ou déformé plastiquement, ce qui modifierait son comportement. Si tel n'était pas le cas, il se comporterait comme dans le cas précédent.

Enfin, si l'organe moteur 1 est armé d'une valeur Δ supérieure à Δ_{max_théorique}, si ce dernier ne voit pas des lames de son organe élastique 6 se rompre ou se déformer plastiquement, il exercera une force F d'abord supérieure à la force F_{constante} sur la plage de positions comprise entre Δₐᵣₘ et Δ_{max_théorique}, puis une force sensiblement constante de valeur environ égale à F_{constante} sur la plage de positions [Δ_{max_théorique}, Δ_{min_théorique}], puis enfin, si aucune butée ne l'empêche de se désarmer complètement, il se désarmera jusqu'à revenir dans sa position de repos (Δ=0). La force alors exercée entre les positions Δ=Δ_{min_théorique} et Δ=0 sera d'intensité décroissante.

De manière avantageuse, le mécanisme horloger intégrant l'organe moteur 1 ou l'organe moteur 1 lui-même peut comprendre des butées permettant de maintenir ledit organe moteur 1 dans la plage de positions [Δ_{min_théo}, Δ_{max_théo}] de sa crémaillère 5 par rapport à son support 7 permettant la délivrance d'une force sensiblement constante. De préférence, lesdites butées permettent de maintenir ledit organe moteur 1 dans la plage de positions [Δ_{min_utilisation}, Δ_{max_utilisation}] de sa crémaillère 5 par rapport à son support 7 permettant la délivrance d'une force sensiblement constante et évitant tout risque de rupture ou de déformation plastique des lames de son organe élastique 6.

Dans une variante de l'invention, la denture 9 pourrait être portée par un élément d'entraînement autre qu'une crémaillère et pourrait coopérer avec une d'autres composés dentés qu'un pignon, par exemple avec une roue dentée ou un râteau. En outre, la crémaillère 5 pourrait être remplacée par exemple par une tige d'entraînement non dentée coopérant avec une roue non dentée par adhérence ou friction ou par tout autre élément d'entraînement 5 apte à délivrer la force de rappel qu'il reçoit de l'organe élastique 6 à un mécanisme.

Comme indiqué précédemment, l'organe moteur 1 peut être réalisé en tout matériau approprié. Comme indiqué précédemment, le matériau choisi pour la réalisation des lames élastiques de l'organe moteur impactera la limite de déformation plastique ou de rupture.

L'organe moteur 1 selon l'invention peut être fabriqué par usinage, notamment dans le cas où il est réalisé en métal ou dans un alliage tel que le Nivaflex^{®}, par gravure DRIE dans le cas du silicium par exemple, ou encore par moulage, notamment dans le cas où il est fabriqué en plastique ou en verre métallique.

Il apparaîtra clairement à l'homme du métier que la présente invention n'est en aucun cas limitée au mode de réalisation présenté ci-dessus et illustré aux figures.

Il est par exemple très bien envisageable de réaliser un organe moteur dont les lames élastiques composant l'organe élastique sont de formes différentes de celles représentées dans les figures ou sont agencées différemment par rapport au mode de réalisation représenté dans les figures. En particulier, l'association d'au moins une lame élastique travaillant en flambage et d'au moins une lame élastique travaillant en flexion peut permettre l'obtention d'une force sensiblement constante, même si celles-ci sont agencées différemment par rapport au mode de réalisation illustré aux figures.

Comme indiqué précédemment, le support de l'organe moteur selon l'invention est typiquement fixé sur la platine du mouvement. En variante, si ladite platine est réalisée dans un matériau à haute élasticité, il est envisageable de réaliser un dispositif monobloc comprenant la platine et l'organe moteur selon l'invention.

La valeur de la de force atteinte dans la phase stable de l'organe moteur peut typiquement être ajustée en modifiant l'épaisseur des lames élastiques que comprend l'organe élastique et/ou le matériau utilisé pour les réaliser.

L'organe moteur 1 selon l'invention peut permettre la mise en mouvement d'un rouage de finissage 3 mais est avantageusement utilisé pour la mise en mouvement d'un mécanisme additionnel indépendant tel qu'un mécanisme de sonnerie ou de chronographe. L'organe moteur 1 selon l'invention peut également être utilisé comme source d'énergie indépendante dans un mécanisme horloger tel que décrit dans la demande de brevet européen déposée sous le numéro 17166832.0.

En plus des nombreux avantages évoqués plus haut, liés notamment à sa structure sans spires, l'organe moteur selon l'invention présente l'avantage de délivrer une force sensiblement constante et améliore ainsi l'isochronisme du mouvement horloger auquel il est associé, sans le compliquer.

## Revendications

1. Organe moteur (1) d'horlogerie comprenant un support (7), un organe élastique (6) et un élément d'entraînement (5) apte à être mis en mouvement et guidé en translation par rapport au support (7) par ledit organe élastique (6), cette translation permettant la délivrance d'une force à un mécanisme horloger, ledit organe moteur (1) étant **caractérisé en ce que** l'organe élastique (6) est conçu pour exercer une force de rappel élastique sensiblement constante sur une plage de positions prédéterminée de l'élément d'entraînement (5) par rapport au support (7).

2. Organe moteur (1) selon la revendication 1, **caractérisé en ce qu'**il est monolithique.

3. Organe moteur (1) selon l'une des revendications précédentes, **caractérisé en ce que** ledit organe élastique (6) comprend au moins une lame élastique (6a) travaillant en flambage et au moins une lame élastique (6b, 6c) travaillant en flexion.

4. Organe moteur (1) selon l'une des revendications précédentes, **caractérisé en ce que** ladite plage prédéterminée de positions de l'élément d'entraînement (5) par rapport au support (7) inclut l'ensemble des positions que peut prendre l'élément d'entraînement (5).

5. Organe moteur (1) selon l'une des revendications précédentes, **caractérisé en ce que** l'élément d'entraînement (5) comprend une crémaillère dont la denture (9) est destinée à coopérer avec la denture d'un composant tel qu'une roue dentée, un pignon denté, un râteau ou tout autre composant denté ou **en ce que** l'élément d'entraînement (5) comprend un élément non denté destiné à coopérer avec un composant non denté par friction.

6. Organe moteur (1) selon l'une de revendications précédentes, **caractérisé en ce que** ledit élément d'entraînement (5) comprend une denture (9), cette denture (9) permettant la délivrance de ladite force audit mécanisme horloger (2, 3).

7. Organe moteur (1) selon l'une des revendications précédentes, **caractérisé en ce qu'**il est armé par translation de son élément d'entraînement (5) dans la même direction et dans le sens opposé à la translation qu'il décrit lorsqu'il délivre ladite force.

8. Mécanisme horloger **caractérisé en ce qu'**il comprend un organe moteur (1) selon l'une quelconque des revendications 1 à 7.

9. Mécanisme horloger selon la revendication précédente, **caractérisé en ce qu'**il comprend des butées permettant de maintenir l'organe moteur (1) dans une plage de positions de son élément d'entraînement (5) par rapport à son support (7) permettant la délivrance d'une force sensiblement constante.

10. Mécanisme horloger selon l'une des revendications 8 ou 9, **caractérisé en ce qu'**il comprend un mécanisme de remontoir agencé pour armer l'organe moteur (1) et un rouage (2) agencé pour être entraîné par l'organe moteur (1).

11. Pièce d'horlogerie, telle qu'une montre bracelet, comprenant un mécanisme horloger selon l'une des revendications 8 à 10.

12. Pièce d'horlogerie selon la revendication 11, **caractérisée en ce qu'**elle comprend une boîte de montre et un mécanisme de remontoir dudit organe moteur, ledit mécanisme de remontoir étant actionnable depuis l'extérieur de la boîte de montre.

13. Utilisation d'un organe moteur selon l'une des revendications 1 à 7 comme source d'énergie pour un mécanisme horloger indépendant du rouage de finissage.

14. Utilisation selon la revendication 13, **caractérisée en ce que** ledit mécanisme comme source d'énergie pour un mécanisme horloger indépendant du rouage de finissage comprend un mécanisme de chronographe ou de sonnerie.

## Patentansprüche

1. Antriebsorgan (1) einer Uhr, das eine Stütze (7), ein elastisches Organ (6) und ein Mitnahmeelement (5) umfasst, das dazu geeignet ist, durch das elastische Organ (6) in Bewegung versetzt zu werden und translatorisch in Bezug auf die Stütze (7) geführt zu werden, wobei diese Translation die Abgabe einer Kraft an einen Uhrmechanismus ermöglicht, wobei das Antriebsorgan (1) **dadurch gekennzeichnet ist, dass** das elastische Organ (6) dazu konzipiert ist, eine im Wesentlichen konstante elastische Rückzugskraft auf einen vorbestimmten Bereich von Positionen des Mitnahmeelements (5) in Bezug auf die Stütze (7) auszuüben.

2. Antriebsorgan (1) nach Anspruch 1, **dadurch gekennzeichnet, dass** es monolithisch ist.

3. Antriebsorgan (1) nach einem der vorhergehenden Ansprüche, **dadurch gekennzeichnet, dass** das elastische Organ (6) mindestens eine elastische Klinge (6a), die in Knickung arbeitet, und mindestens eine elastische Klinge (6b, 6c) umfasst, die in Biegung arbeitet.

4. Antriebsorgan (1) nach einem der vorhergehenden Ansprüche, **dadurch gekennzeichnet, dass** der vorbestimmte Bereich von Positionen des Mitnahmeelements (5) in Bezug auf die Stütze (7) die Gesamtheit der Positionen umfasst, die das Mitnahmeelement (5) einnehmen kann.

5. Antriebsorgan (1) nach einem der vorhergehenden Ansprüche, **dadurch gekennzeichnet, dass** das Mitnahmeelement (5) eine Zahnstange umfasst, deren Zahnung (9) dazu bestimmt ist, mit der Zahnung eines Bauteils, wie beispielsweise eines Zahnrads, eines Zahntriebs, eines Rechens oder jedes anderen gezahnten Bauteils, zusammenzuwirken, oder dadurch, dass das Mitnahmeelement (5) ein nicht gezahntes Element umfasst, das dazu bestimmt ist, durch Reibung mit einem nicht gezahnten Bauteil zusammenzuwirken.

6. Antriebsorgan (1) nach einem der vorhergehenden Ansprüche, **dadurch gekennzeichnet, dass** das Mitnahmeelement (5) eine Zahnung (9) umfasst, wobei diese Zahnung (9) die Abgabe der Kraft an den Uhrmechanismus (2, 3) ermöglicht.

7. Antriebsorgan (1) nach einem der vorhergehenden Ansprüche, **dadurch gekennzeichnet, dass** es durch Translation seines Mitnahmeelements (5) entlang der gleichen Geraden und in der Richtung entgegengesetzt zur Translation, die es beschreibt, wenn es die Kraft abgibt, gespannt wird.

8. Uhrmechanismus, **dadurch gekennzeichnet, dass** er ein Antriebsorgan (1) nach einem der Ansprüche 1 bis 7 umfasst.

9. Uhrmechanismus nach dem vorhergehenden Anspruch, **dadurch gekennzeichnet, dass** er Anschläge umfasst, die das Halten des Antriebsorgans (1) in einem Bereich von Positionen seines Mitnahmeelements (5) in Bezug auf seine Stütze (7) ermöglicht, welche die Abgabe einer im Wesentlichen konstanten Kraft ermöglichen.

10. Uhrmechanismus nach einem der Ansprüche 8 oder 9, **dadurch gekennzeichnet, dass** er einen Aufzugsmechanismus umfasst, der dazu gestaltet ist, das Antriebsorgan (1) und ein Räderwerk (2) zu spannen, das dazu gestaltet ist, von dem Antriebsorgan (1) mitgenommen zu werden.

11. Uhr, wie beispielsweise eine Armbanduhr, die einen Uhrmechanismus nach einem der Ansprüche 8 bis 10 umfasst.

12. Uhr nach Anspruch 11, **dadurch gekennzeichnet, dass** sie ein Uhrgehäuse und einen Aufzugsmechanismus des Antriebsorgans umfasst, wobei der Aufzugsmechanismus von außerhalb des Uhrgehäuses betätigbar ist.

13. Verwendung eines Antriebsorgans nach einem der Ansprüche 1 bis 7 als Energiequelle für einen Uhrmechanismus, der vom Finissage-Räderwerk unabhängig ist.

14. Verwendung nach Anspruch 13, **dadurch gekennzeichnet, dass** der Mechanismus als Energiequelle für einen Uhrmechanismus, der unabhängig vom Finissage-Räderwerk ist, einen Chronographen- oder Läutwerkmechanismus umfasst.

## Claims

1. Driving member (1) for timepieces comprising a support (7), an elastic member (6) and a drive element (5) able to be set in motion and guided in translation with respect to the support (7) by said elastic member (6), this translation permitting the delivery of a force to a timepiece mechanism, said driving member (1) being **characterised in that** the elastic member (6) is designed to exert an elastic return force which is substantially constant over a predetermined range of positions of the drive element (5) with respect to the support (7).

2. Driving member (1) as claimed in claim 1, **characterised in that** it is formed of one piece.

3. Driving member (1) as claimed in any one of the preceding claims, **characterised in that** said elastic member (6) comprises at least one elastic strip (6a) operating in a buckling manner and at least one elastic strip (6b, 6c) operating in a bending manner.

4. Driving member (1) as claimed in any one of the preceding claims, **characterised in that** said predetermined range of positions of the drive element (5) with respect to the support (7) includes all of the positions that the drive element (5) may assume.

5. Driving member (1) as claimed in any one of the preceding claims, **characterised in that** the drive element (5) comprises a rack, the teeth (9) of which are intended to cooperate with the teeth of a component such as a toothed wheel, a toothed pinion, a bed or any other toothed component or **in that** the drive element (5) comprises a non-toothed element intended to cooperate with a non-toothed component by means of friction.

6. Driving member (1) as claimed in any one of the preceding claims, **characterised in that** said drive element (5) comprises a toothing (9), this toothing (9) permitting the delivery of said force to said timepiece mechanism (2, 3).

7. Driving member (1) as claimed in any one of the preceding claims, **characterised in that** it is wound by translation of its drive element (5) along the same straight line and in the direction opposite to the translation which it describes when it delivers said force.

8. Timepiece mechanism **characterised in that** it comprises a driving member (1) as claimed in any one of claims 1 to 7.

9. Timepiece mechanism as claimed in the preceding claim, **characterised in that** it comprises stops enabling the driving member (1) to be kept within a range of positions of its drive element (5) with respect to its support (7) permitting the delivery of a substantially constant force.

10. Timepiece mechanism as claimed in any one of claims 8 or 9, **characterised in that** it comprises a winding mechanism arranged to wind the driving member (1) and a gear train (2) arranged to be driven by the driving member (1).

11. Timepiece, such as a wrist watch, comprising a timepiece mechanism as claimed in any one of claims 8 to 10.

12. Timepiece as claimed in claim 11, **characterised in that** it comprises a watch case and a winding mechanism for said driving member, said winding mechanism being operable from outside the watch case.

13. Use of a driving member as claimed in any one of claims 1 to 7 as a power source for a timepiece mechanism independent of the going train.

14. Use as claimed in claim 13, **characterised in that** said mechanism as a power source for a timepiece mechanism independent of the going train comprises a chronograph or striking mechanism.
